Europäisches Patentamt

European Patent Office

Office européen des brevets

(19)

(11) Numéro de publication : **0 506 562 A1**

# (12) DEMANDE DE BREVET EUROPEEN

(21) Numéro de dépôt : **92400826.1**

(22) Date de dépôt : **26.03.92**

(51) Int. Cl.⁵ : **H05K 3/32, H01R 43/02**

(30) Priorité : **28.03.91 FR 9104210**

(43) Date de publication de la demande :
**30.09.92 Bulletin 92/40**

(84) Etats contractants désignés :
**AT BE CH DE ES GB IT LI NL SE**

(71) Demandeur : **Lambert, François**
**3, rue Marcel Doret**
**F-78140 Velizy (FR)**

(72) Inventeur : **Lambert, François**
**3, rue Marcel Doret**
**F-78140 Velizy (FR)**

(74) Mandataire : **Boivin, Claude**
**9, rue Edouard-Charton**
**F-78000 Versailles (FR)**

(54) **Procédé de raccordement électrique.**

(57)     Procédé de raccordement électrique d'une première pièce portant une série d'éléments de connexion à une seconde pièce portant également une série d'éléments de connexion ayant la même disposition relative que les éléments de la première pièce.

On dépose sur la première pièce (4 ou 13) au droit de ses éléments de connexion (5 ou 15) une résine thermo-durcissable (6 ou 14) devenant conductrice après durcissement. On chauffe les éléments de connexion (2 ou 17) de la seconde pièce (1 ou 12) et on met en contact les éléments de connexion de la seconde pièce avec ceux de la première pièce.

FIG.7

EP 0 506 562 A1

La présente invention concerne le raccordement électrique d'une première pièce portant une série d'éléments de connexion à une seconde pièce portant également une série d'éléments de connexion ayant la même disposition relative que les éléments de la première pièce. Le problème se pose par exemple pour raccorder une nappe souple de conducteurs électriques à un composant tel qu'un afficheur à cristaux liquides, un contacteur ou un potentiomètre, ou encore pour assurer la connexion d'un composant sur un substrat par exemple un circuit imprimé.

Le plus souvent, on utilise la technique de brasage mais sa mise en oeuvre est difficile, voire impossible dans le cas de pas très serré ou de matériaux non soudables tels que d'oxyde d'étain ou d'indium. On peut alors utiliser une bande en élastomère constituée de fines bandes alternées conductrices et isolantes; mais il est impossible de réaliser des connexions dans une direction perpendiculaire aux bandes. On peut également procéder à un collage anisotrope à l'aide d'une colle qui, sous pression, devient conductrice au moment de la cuisson. Mais ce procédé est très délicat et sa fiabilité est incertaine.

La présente invention a pour objet un procédé de raccordement qui évite ces inconvénients.

Ce procédé est caractérisé en ce qu'on dépose sur la première pièce, au droit de ses éléments de connexion une résine thermo-durcissable devenant conductrice après durcissement, qu'on chauffe les éléments de connexion de la seconde pièce et qu'on met en contact les éléments de connexion de la seconde pièce avec ceux de la première pièce. La résine se trouvant entre les deux séries d'éléments de connexion durcit alors et devient conductrice en assurant le raccordement de ces deux séries d'éléments alors que la résine se trouvant à côté des éléments de la première pièce n'est pas chauffée et donc non durcie; elle n'est donc pas conductrice et peut être retirée par un simple lavage.

On a décrit ci-après, à titre d'exemple non limitatif, deux modes de mise en oeuvre du procédé selon l'invention, avec référence aux dessins annexés dans lesquels :

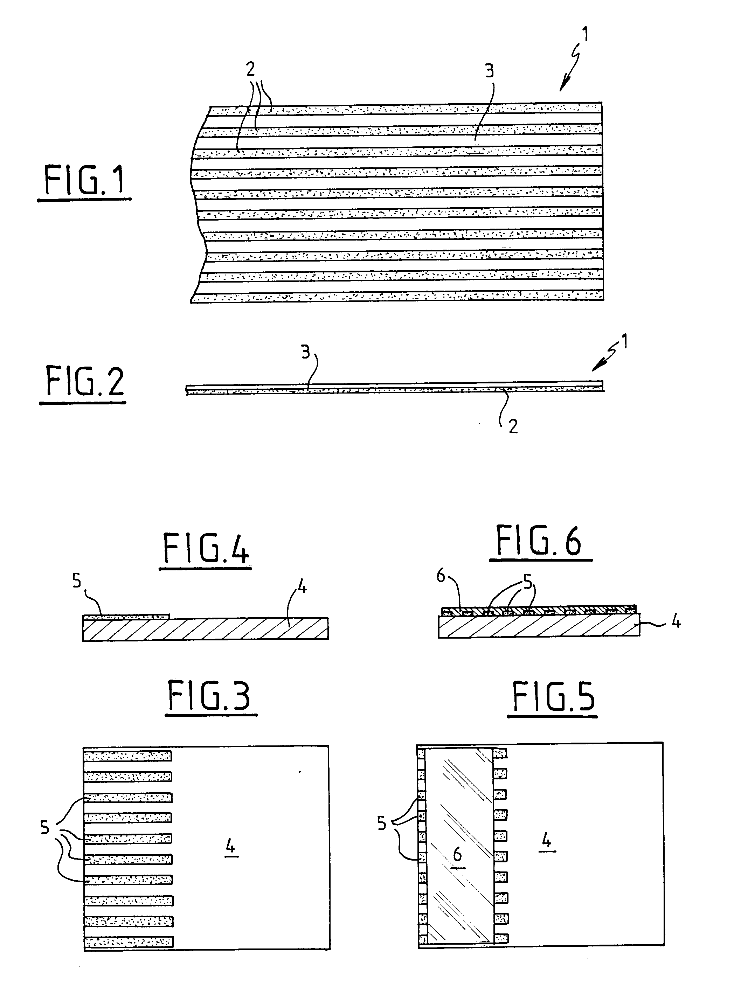

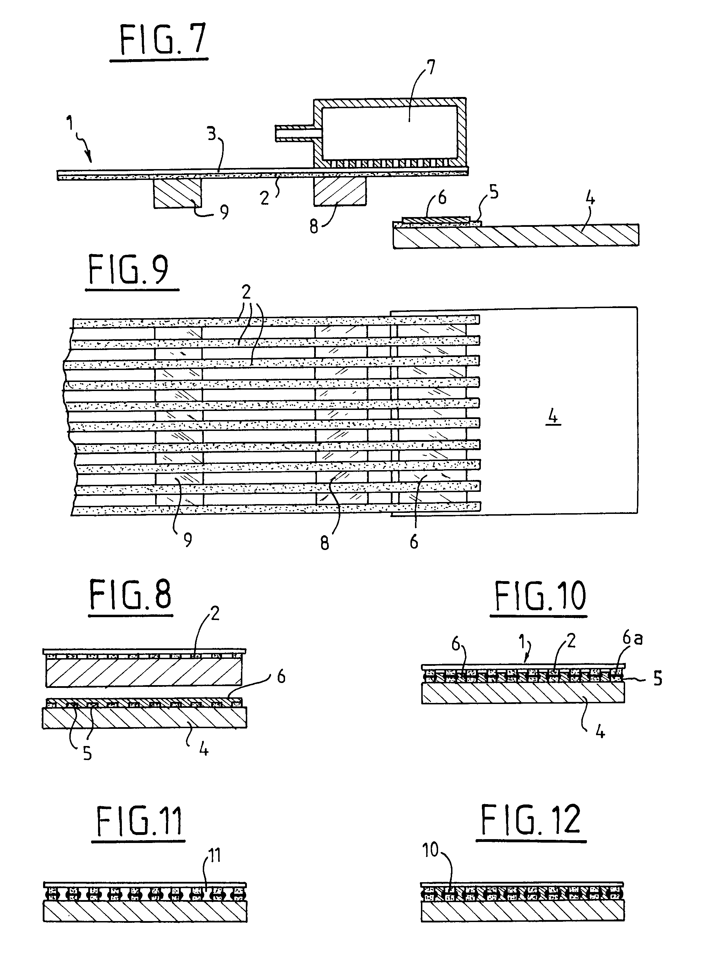

Les Figures 1 à 12 sont des schémas illustrant un premier mode de mise en oeuvre;
Les Figures 13 à 20 sont des schémas illustrant un second mode de mise en oeuvre.

Pour raccorder un circuit souple 1, qui est constitué de bandes métalliques parallèles 2 sur une feuille de matière plastique souple 3, par exemple en résine polyimide ou polyester, à un composant 4 portant des connexions conductrices parallèles 5 en métal ou en une autre matière conductrice, par exemple en oxyde d'étain ou d'indium, au même pas que les bandes 2, on opère comme indiqué ci-après.

On dépose sur les connexions électriques 5, par exemple par sérigraphie, par stencil ou par transfert, une résine thermo-durcissable 6 devenant conductrice après durcissement, par exemple une résine époxide chargée à l'argent telle que celle fabriquée par la société EPO-TEK et vendue sous la dénomination H2OE; une telle résine réticule en environ trente secondes à une température de 175° C.

Le circuit souple 1 est alors saisi par exemple par un dispositif de préhension à vide 7 et chauffé par exemple avec une masse chaude thermostatée 8 sur laquelle la surface des bandes métalliques 2 est plaquée à une faible distance de la zone de ses bandes devant être raccordée aux éléments de connexion 5; on peut assurer le chauffage par d'autres moyens tels que des résistances, de l'air chaud ou des micro-ondes. La chaleur est transmise par les bandes 2 à la zone de ces bandes devant être raccordée au composant 4. Par contre, la bande 3 qui est thermiquement isolante, n'est pas chauffée; on peut éventuellement bloquer la transmission de la chaleur vers la partie du circuit 1 opposée à la zone devant être raccordée au composant 4 en plaquant une masse froide sur les bandes de cette partie.

On pose ensuite les bandes chaudes 2 du circuit 1 sur la résine 6, ce qui assure en quelques secondes l'échauffement et le durcissement des parties de cette résine se trouvant au contact de ces bandes 2. Ces parties deviennent conductrices et assurent le raccordement des bandes 2 et des connexions 5 entre lesquelles elles se trouvent, comme indiqué en 6a. Par contre, les parties de la résine 6 se trouvant entre les bandes 2 restent froides, donc non durcies et isolantes.

On peut alors enlever par un solvant la résine non durcie qui se trouve entre les raccordements réalisés, pour éviter tout court-circuit ultérieur et remplir avec une résine isolante 10 les alvéoles 11 ainsi formés, ce qui améliore la résistance mécanique de l'assemblage ainsi que l'isolement électrique entre les contacts, protège contre les attaques de l'environnement et évite les oxydations éventuelles des matériaux.

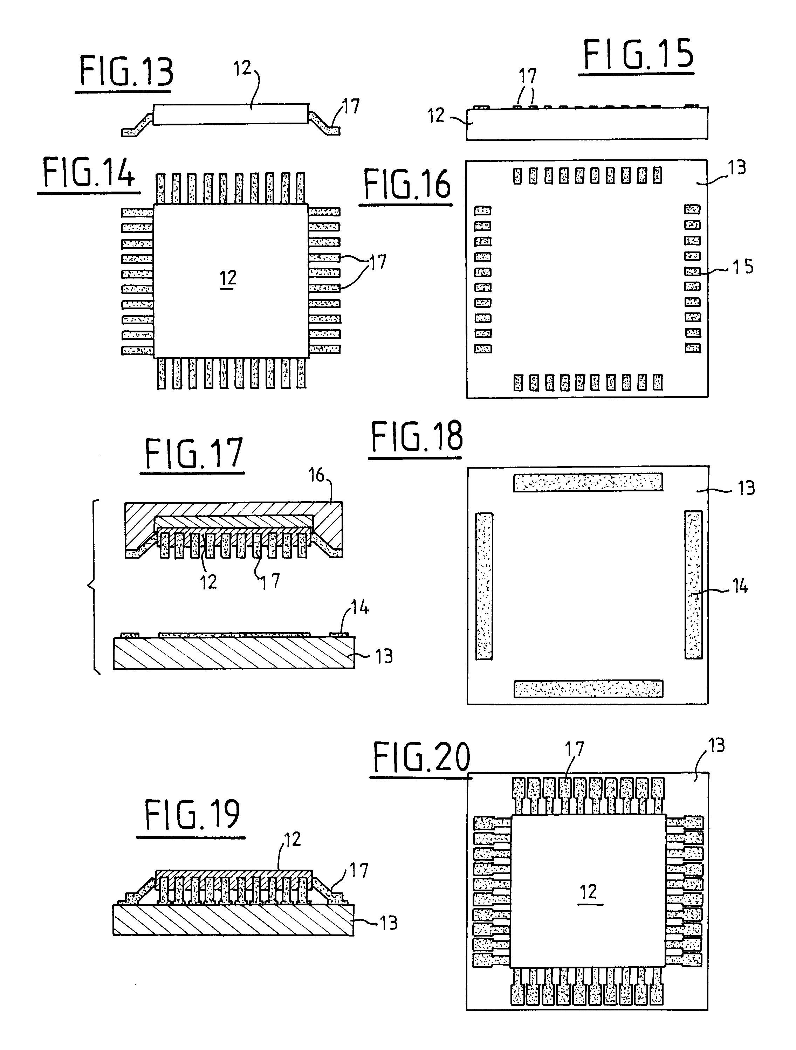

Les Figures 13 à 20 montrent l'application du procédé à la connexion d'un composant électronique 12 sur un substrat 13. On recouvre d'un mince couche de résine durcissable 14 devenant conductrice de l'électricité les contacts 15 du substrat 13 et, à l'aide d'une masse chauffante 16, on porte simultanément toutes les électrodes 17 des composants 12 à la température de durcissement de la résine 14. Les électrodes étant chaudes, on pose le composant 12 sur la résine. Celle-ci est durcie uniquement sous les électrodes 17 et un lavage permet d'éliminer la résine non durcie.

Il va de soi que la présente invention ne doit pas être limitée aux modes de mise en oeuvre décrits et représentés, mais en couvre, au contraire, toutes les variantes. C'est ainsi, par exemple, qu'on pourrait augmenter la vitesse d'échauffement des extrémités des bandes 2 en faisant glisser le circuit 1 à travers le dispositif de chauffage; cela est particulièrement indiqué dans le cas du chauffage à haute fréquence.

**Revendications**

1. Procédé de raccordement électrique d'une première pièce portant une série d'éléments de connexion à une seconde pièce portant également une série d'éléments de connexion ayant la même disposition relative que les éléments de la première pièce, caractérisé en ce qu'on dépose sur la première pièce (4 ou 13) au droit de ses éléments de connexion (5 ou 15) une résine thermo-durcissable (6 ou 14) devenant conductrice après durcissement, qu'on chauffe les éléments de connexion (2 ou 17) de la seconde pièce (1 ou 12) et qu'on met en contact les éléments de connexion de la seconde pièce avec ceux de la première pièce.

2. Procédé selon la revendication 1, caractérisé en ce que la seconde pièce 1 est constituée par une feuille de matière plastique souple portant une série de bandes métalliques 2 alors que la première pièce 4 est un composant.

3. Procédé selon la revendication 1, caractérisé en ce que la première pièce (13) est un substrat alors que la seconde pièce (12) est un composant devant être raccordé à la surface de la première pièce.

4. Procédé selon l'une des revendications 1 à 3, caractérisé en ce qu'on chauffe les éléments de connexion (2) à une certaine distance de leur zone devant être raccordée aux éléments de connexion (5).

5. Procédé selon la revendication 4, caractérisé en ce qu'on refroidit la partie des éléments de connexion (2) opposée à la zone devant être raccordée aux éléments de connexion (5).

6. Procédé selon l'une des revendications 1 à 4, caractérisé en ce qu'on retire à l'aide d'un solvant la résine (6) non durcie.

7. Procédé selon la revendication 6, caractérisé en ce qu'on remplit à l'aide d'une résine isolante (10) les alvéoles (11) formés par le retrait de la résine (6) non durcie.

8. Procédé selon l'une des revendications précédentes, caractérisé en ce qu'on chauffe les éléments de connexion (2) en faisant glisser la pièce (1) au travers du dispositif de chauffage.

## FIG.1

## FIG.2

## FIG.4

## FIG.6

## FIG.3

## FIG.5

## FIG. 7

## FIG. 9

## FIG. 8

## FIG. 10

## FIG. 11

## FIG. 12

FIG.13

FIG.14

FIG.15

FIG.16

FIG.17

FIG.18

FIG.19

FIG.20

EP 0 506 562 A1

| | Office européen des brevets | **RAPPORT DE RECHERCHE EUROPEENNE** | Numero de la demande |
|---|---|---|---|

EP    92 40 0826

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | FR-A-2 282 148 (KABUSHIKI KAISHA SEIKOSHA) * page 5, ligne 9 - page 6, ligne 14; figures 1,2 * | 1-4,8 | H05K3/32 H01R43/02 |
| A | DE-A-2 831 984 (SHARP K.K.) * page 10, ligne 6 - ligne 33 * | 1-4 | |

**DOMAINES TECHNIQUES RECHERCHES (Int. Cl.5 )**

H01R
H05K

Le présent rapport a été établi pour toutes les revendications

| Lieu de la recherche | Date d'achèvement de la recherche | Examinateur |
|---|---|---|
| LA HAYE | 07 MAI 1992 | CRIQUI J.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

EPO FORM 1503 03.82 (P0402)

7